(19) **Europäisches Patentamt**

**European Patent Office**

**Office européen des brevets**

(11) Veröffentlichungsnummer: **0 387 822**
**A1**

(12) **EUROPÄISCHE PATENTANMELDUNG**

(21) Anmeldenummer: **90104780.3**

(22) Anmeldetag: **14.03.90**

(51) Int. Cl.5: **G03F 7/09, G03F 7/30, H05K 3/06**

(30) Priorität: **15.03.89 DE 3908409**

(43) Veröffentlichungstag der Anmeldung:
**19.09.90 Patentblatt 90/38**

(84) Benannte Vertragsstaaten:
**BE CH DE FR GB IT LI NL**

(71) Anmelder: **BASF Aktiengesellschaft**
**Carl-Bosch-Strasse 38**
**D-6700 Ludwigshafen(DE)**

(72) Erfinder: **Seitz, Friedrich, Dr.**
**Von-Wieser-Strasse 1**
**D-6701 Friedelsheim(DE)**
Erfinder: **Huemmer, Wolfgang, Dr.**
**Vischerstrasse 16**
**D-6703 Limburgerhof(DE)**

(54) **Lichtempfindliches Aufzeichnungsmaterial und Verfahren zur Herstellung gedruckter Schaltungen.**

(57) Die Erfindung betrifft ein lichtempfindliches Aufzeichnungsmaterial und ein Verfahren zur Herstellung gedruckter Schaltungen.

Das lichtempfindliche Aufzeichnungsmaterial besteht aus

(i) einer Trägerfolie;

(ii) einer photoempfindlichen positiv oder negativ arbeitenden Schicht und

(iii) gegebenenfalls darauf aufgebrachten weiteren Schichten, wobei die Trägerfolie (i) und die nach der bildmäßigen Belichtung zu entfernenden Bereiche der Schicht (ii) in der gleichen Entwicklerlösung löslich oder dispergierbar sind.

Dieses Aufzeichnungsmaterial eignet sich zur Herstellung gedruckter Schaltungen.

EP 0 387 822 A1

## Lichtempfindliches Aufzeichnungsmaterial und Verfahren zur Herstellung gedruckter Schaltungen

Die Erfindung betrifft ein lichtempfindliches Aufzeichnungsmaterial, das mindestens aus einer Trägerfolie und einer darauf aufgebrachten photoempfindlichen Schicht besteht, sowie ein Verfahren zur Herstellung gedruckter Schaltungen.

Lichtempfindliche Aufzeichnungsmaterialien bestehen üblicherweise mindestens aus einem dimensionsstabilen Träger und einer darauf aufgebrachten photoempfindlichen Schicht. So ist es zum Beispiel üblich, für die Herstellung von Hochdruck- oder Tiefdruckplatten eine photopolymerisierbare Schicht auf einen Träger aus Metall oder Kunststoff aufzubringen. Offsetdruckplatten können durch Aufbringen einer lichtempfindlichen Schicht auf ein geeignet vorbehandeltes Aluminiumblech hergestellt werden. Photoresistfilme bestehen üblicherweise aus einer Trägerfolie aus Polyethylenterephthalat, auf die eine lichtempfindliche Schicht aufgebracht ist, auf die wiederum eine Deckfolie aus Polyethylen laminiert ist. In vielen Fällen ist es erforderlich, die Trägerfolie im Lauf der Verarbeitung abzuziehen. Beispielsweise kann nach US-A-3 469 982 eine gedruckte Schaltung dadurch hergestellt werden, daß, in der angegebenen Reihenfolge, eine auf einer Trägerfolie aufgebrachte photopolymerisierbare Schicht auf eine geeignete Oberfläche aufgebracht wird, die photopolymersierbare Schicht durch die Trägerfolie hindurch bildmäßig belichtet wird, die Trägerfolie dann abgezogen wird und die nicht belichteten Teile der photopolymerisierbaren Schicht durch eine geeignete Entwicklerlösung entfernt werden. Das Abziehen der Trägerfolie erfolgt an den vereinzelten Platten und ist daher nur schwer zu automatisieren. Es wird daher meist von Hand durchgeführt, was mit hohen Personalkosten verbunden ist. Es sind auch mechanische Vorrichtungen im Handel, die die Trägerfolie mit Hilfe eines Klebebandes oder eines mechanischen Greifers erfassen und auf diese Weise das Abziehen der Trägerfolie besorgen sollen. Jedoch erfordern die genannten Vorrichtungen zusätzliche Investitionen und sind zudem störanfällig.

In der DE-A-20 22 849 wird ein Verfahren beschrieben, in dem eine lichtempfindliche Schicht unter Verwendung einer löslichen Trägerfolie auf ein Substrat aufgebracht wird. Charakteristisch für das Verfahren nach DE-A-20 22 849 ist, daß die photoempfindliche Schicht im Lösungsmittel für die Trägerfolie unlöslich ist. Die Trägerfolie wird nach dem Beschichten des Substrats, aber vor dem Belichten, durch Auflösen in einem Lösungsmittel, in dem die photoempfindliche Schicht unlöslich ist, entfernt. Obwohl hierdurch die durch das Abziehen der Trägerfolie verursachten Schwierigkeiten vermieden werden, entsteht ein neues Problem, das eine breite Anwendung dieses Verfahrens bisher verhindert hat: Bei diesem Verfahren kommt die bildmäßige Vorlage bei der üblichen Kontaktbelichtung in direkten Kontakt mit der photoempfindlichen Schicht. Da die photoempfindliche Schicht wegen der nötigen Haftung zur Substratoberfläche stets etwas klebrig ist, führt dies zu einer raschen Verschmutzung der bildmäßigen Vorlagen. Der dadurch notwendige häufige Austausch der bildmäßigen Vorlagen erhöht die Kosten des Verfahrens. In der DE-A-20 22 849 ist auch erwähnt, daß die Trägerschicht, falls sie transparent ist, erst nach dem Belichten entfernt werden kann. In allen Fällen werden jedoch Trägerschicht und lichtempfindliche Schicht mit zwei verschiedenen Entwicklerlösungen, d.h. notwendigerweise in zwei getrennten Arbeitsgängen, entfernt.

Es wurde nun überraschenderweise gefunden, daß bei geeigneter Wahl von Trägerfolie und photoempfindlicher Schicht das Entfernen der Trägerfolie zusammen mit dem Entwickeln der photoempfindlichen Schicht in einem Arbeitsgang erfolgen kann. Auf diese Weise kann ohne Beeinträchtigung der übrigen Eigenschaften des lichtempfindlichen Aufzeichnungsmaterials das Abziehen der Trägerfolie vermieden werden. Gegenüber dem in DE-A-20 22 849 beschriebenen Stand der Technik wird eine Verschmutzung der bildmäßigen Vorlagen sowie ein zusätzlicher Arbeitsgang vermieden.

Gegenstand der vorliegenden Erfindung ist ein lichtempfindliches Aufzeichnungsmaterial, bestehend aus

(i) einer Trägerfolie;

(ii) einer photoempfindlichen positiv oder negativ arbeitenden Schicht und

(iii) gegebenenfalls darauf aufgebrachten weiteren Schichten, das dadurch gekennzeichnet ist, daß die Trägerfolie (i) und die nach der bildmäßigen Belichtung zu entfernenden Bereiche der Schicht (ii) in der gleichen Entwicklerlösung löslich oder dispergierbar sind und es sich bei dieser Entwicklerlösung um Wasser oder eine wäßrige Lösung handelt.

Die Trägerfolie (i) für das erfindungsgemäße lichtempfindliche Aufzeichnungsmaterial kann durch Extrusion oder durch Gießen hergestellt werden. Die Trägerfolie (i) besteht vorzugsweise aus vollständig oder teilweise verseiftem Polyvinylacetat. Die photoempfindliche Schicht (ii) ist vorzugsweise mit einer Deckfolie, z.B. aus Polyethylen oder Polypropylen, abgedeckt.

Gegenstand der vorliegenden Erfindung ist auch ein Verfahren zur Herstellung einer gedruckten Schaltung, wobei in der angegebenen Reihenfolge (1) ein erfindungsgemäßes lichtempfindliches Aufzeichnungsmaterial, gegebenenfalls nach Abziehen der Deckfolie, so auf ein kupferkaschiertes Leiterplattensubstrat auflaminiert wird, daß die photoempfindliche Schicht (ii) in Kontakt zur Kupferoberfläche steht, (2) die lichtempfindliche Aufzeichnungsschicht bildmäßig belichtet wird, (3) die Trägerfolie und die löslichen Stellen der photoempfindlichen Schicht in einer wäßrigen Entwicklerlösung entfernt werden und (4) die freigelegte Kupferoberfläche den üblichen weiteren Bearbeitungsschritten wie Ätzen oder galvanischer Metallabscheidung unterworfen wird.

Als Entwicklerlösung bevorzugt ist dabei eine wäßrige Natriumcarbonat-Lösung.

Hinsichtlich der aufzubringenden photoempfindlichen Schicht bestehen keine Einschränkungen, außer daß eine ausreichende Haftung zwischen photoempfindlicher Schicht und löslicher Trägerfolie gegeben sein sollte.

Trägerfolie (i) und photoempfindliche Schicht (ii) werden so aufeinander abgestimmt, daß die Trägerfolie und die photoempfindliche Schicht in der gleichen Entwicklerlösung löslich sind, so daß das Auflösen der Trägerfolie und das Entwickeln der photoempfindlichen Schicht in einem Arbeitsgang erfolgen können.

In einer bevorzugten Ausführungsform wird das erfindungsgemäße lichtempfindliche Aufzeichnungsmaterial als Photoresistfilm verwendet. Es kann sich dabei um negativ oder positiv arbeitende Photoresistfilme handeln. Die vorliegende Erfindung betrifft bevorzugt Photoresistfilme, die wäßrig-alkalisch entwickelt werden.

Als Material für die Trägerfolie (i) kann jedes Material verwendet werden, das in Wasser oder einer wäßrigen Lösung löslich oder dispergierbar ist. Bevorzugt werden Trägerfolien aus Materialien verwendet, die in Wasser oder wäßrigen Lösungen löslich sind, wie z.B. teilweise oder vollständig verseiftes Polyvinylacetat, Cellulose, Hydroxyalkylcellulose und deren Derivate, Polyvinylpyrrolidon und carboxylgruppenhaltige Polymere, insbesondere Copolymere verschiedener Acrylate und Methacrylate mit Acrylsäure oder Methacrylsäure oder Copolymere aus Styrol, einem oder mehreren Acrylaten oder Methacrylaten und Acryl- oder Methacrylsäure, wasserlösliche Polyamide und Copolymere aus Styrol, Maleinsäurehalbestern und Maleinsäureanhydrid. Für den Fachmann selbstverständlich, wird man die Zusammensetzung so wählen, daß man eine klebfreie Trägerfolie erhält. Es ist ebenfalls für den Fachmann selbstverständlich, daß die Materialien zur Herstellung der Trägerfolie so gewählt werden müssen, daß sie in dem Bereich des elektromagnetischen Spektrums, in dem die Belichtung erfolgen soll, transparent sind.

Die in Wasser oder wäßriger Lösung löslichen Trägerfolien (i) können durch Gießen oder Extrudieren hergestellt werden. Die photoempfindliche Schicht kann z.B. durch Sprühen oder Gießen einer Lösung in einem geeigneten Lösemittel oder durch Kaschieren auf die Trägerfolie aufgebracht werden. Besonders günstig ist es, zunächst eine lösliche Trägerfolie auf einem Hilfsträger herzustellen, danach die photoempfindliche Schicht auf die mit der löslichen Trägerfolie beschichtete Seite des Hilfsträgers aufzubringen und schließlich den Hilfsträger abzuziehen, so daß ein Verbund aus löslicher Trägerfolie und photoempfindlicher Schicht entsteht. Der Hilfsträger kann gegebenenfalls wiederverwendet werden.

Zur Zusammensetzung der photoempfindlichen Schicht (ii) ist folgendes zu sagen:

Als lichtempfindliche, negativ arbeitende wäßrig-alkalisch entwickelbare Schichten eignen sich im allgemeinen solche, die im wesentlichen bestehen aus einem Gemisch aus

a) einem oder mehreren in wäßrig-alkalischen Lösungen löslichen oder zumindest dispergierbaren filmbildenden polymeren Bindemitteln,

b) einer oder mehreren photopolymerisierbaren organischen monomeren Verbindungen mit mindestens einer ethylenisch ungesättigten Doppelbindung, die gegebenenfalls teilweise durch eine oder mehrere oligomere Verbindungen mit mindestens einer ethylenisch ungesättigten Doppelbindung ersetzt sein können,

c) einem Photoinitiator oder Photoinitiatorsystem und

d) üblichen Zusatz- und Hilfsstoffen.

a) Als in wäßrig-alkalischen Lösungen lösliche oder zumindest dispergierbare polymere Bindemittel kommen carboxylgruppenhaltige oder Carbonsäureanhydrid-Gruppen enthaltende Copolymerisate in Betracht, wie z.B. Styrol/Maleinsäureanhydrid-Copolymerisate, Styrol/Maleinsäurehalbester-Copolymerisate, Alkyl(meth)acrylat/(Meth)acrylsäure-Copolymerisate, Copolymerisate aus Styrol, Alkyl(meth)acrylaten und (Meth)acrylsäure sowie gegebenenfalls anderen Monomeren (vgl. u.a. DE-B-20 27 467, DE-A-22 05 146, EP-A-49 504 oder DE-A-27 36 058) oder Copolymerisate, die Acrylsäure und/oder Methacrylsäure, hydrophobe Comonomere und N-Vinylamide einpolymerisiert enthalten, wie sie beispielsweise in DE-A-34 47 356 beschrieben sind. Derartige Copolymerisate können beispielsweise 10 bis 50 Gew.% eines Vinylamids, wie z.B. N-Vinylformamid, N-Vinylacetamid, N-Vinyl-N-Methylacetamid oder N-Vinyllactame, wie N-Vinylpyrrolidon und/oder N-Vinylcaprolactam, 5 bis 30 Gew.% Acrylsäure und/oder Methacrylsäure sowie 30 bis 80 Gew.% mindestens eines hydrophoben Comonomeren, welches als solches in Wasser und wäßrig-alkalischen Lösungen unlösliche Homopolymerisate bildet, einpolymerisiert enthalten.

Als Beispiele für die letztgenannten hydrophoben Comonomeren seien genannt: Vinylaromaten, wie z.B. Styrol, substituierte Styrole, die in der Seitenkette oder im Kern beispielsweise durch Alkylgruppen oder Halogenatome substituiert sind, wie α-Methylstyrol, p-Methylstyrol und dergleichen, Vinylacetat sowie die Ester der Acrylsäure und Methacrylsäure, insbesondere die Acrylate und Methacrylate von geradkettigen oder verzweigten Monoalkanolen, vorzugsweise mit 1 bis 4 C-Atomen, wobei hierunter unter anderem das Methylmethacrylat besonders günstig ist. Das Copolymerisat kann ein oder mehrere der hydrophoben Comonomeren einpolymerisiert enthalten, wobei der Anteil der hydrophoben Comonomer-Einheiten in dem Copolymerisat 30 bis 80 Gew.% vorzugsweise 40 bis 70 Gew.%, bezogen auf das Copolymerisat, betragen kann.

Beispiele für Copolymerisate für den Einsatz als polymeres Bindemittel in den lichtempfindlichen Schichten (ii) sind u.a. N-Vinyllactam/(Meth)acrylsäure/Methylmethacrylat-Copolymerisate oder N-Vinyllactam/(Meth)acrylsäure/Styrol-Copolymerisate. In einer typischen Ausführungsform können diese Copolymerisate die Comonomeren beispielsweise in Mengen von 25 bis 35 Gew.% an N-Vinylcaprolactam und/oder N-Vinylpyrrolidon, 5 bis 15 Gew.% an (Meth)acrylsäure und 55 bis 65 Gew.% an den hydrophoben Comonomeren, jeweils bezogen auf das Copolymerisat, einpolymerisiert enthalten.

Beispiele für weitere geeignete polymere Bindemittel (a) sind Styrol-(Meth)-acrylsäure/Methylmethacrylat/Ethylacrylat-Copolymerisate, die z.B. 10 bis 40 % Styrol, 20 bis 30 % Methacrylsäure, 5 bis 50 % Methylmethacrylat und bis zu 50 % Ethylacrylat einpolymerisiert enthalten können.

Die Comonomeren für die einzusetzenden Copolymerisate (a) werden nach Art und Menge in dem vorstehend angegebenen allgemeinen Rahmen so ausgewählt, daß die Copolymerisate filmbildend sind und die an sie gestellten Forderungen bezüglich ihrer Löslichkeit bzw. Dispergierbarkeit erfüllen. Gegebenenfalls können auch Gemische geeigneter carboxylgruppenhaltiger Copolymerisate eingesetzt werden.

Die als polymeres Bindemittel einzusetzenden Copolymerisate können nach den an sich bekannten und üblichen Polymerisationsmethoden durch Copolymerisation der Comonomeren, beispielsweise in Lösung, hergestellt werden. Für die Lösungspolymerisation eignen sich z.B. niedere Alkanole, Ketone, Ester und ähnliche, wie Methanol, Aceton, Methylethylketon, Ethylacetat etc., als Lösungsmittel. Als Polymerisationsinitiatoren kommen die üblichen radikalischen Starter, wie beispielsweise Azobisisobutyronitril, Benzoylperoxid und dergleichen in Betracht.

Das polymere Bindemittel (a) kann in der lichtempfindlichen Aufzeichnungsschicht im allgemeinen in einer Menge von 1 bis 90 %, vorzugsweise 20 bis 70 Gew.%, bezogen auf Gesamtgewicht der Aufzeichnungsschicht enthalten sein.

Neben dem polymeren Bindemittel (a) enthält die lichtempfindliche Schicht (ii) im allgemeinen mindestens eine ethylenisch ungesättigte, photopolymerisierbare Verbindung (b), mindestens einen Photopolymerisationsinitiator bzw. ein Photopolymerisationsinitiatorsystem (c) sowie gegebenenfalls weitere Zusatz- und/oder Hilfsstoffe (d) zur Verbesserung und/oder Modifizierung der allgemeinen Eigenschaften der lichtempfindlichen Schicht (ii).

b) Als photopolymerisierbare organische monomere Verbindungen mit mindestens einer ethylenisch ungesättigten Doppelbindung kommen die üblichen ethylenisch ungesättigten photopolymerisierbaren Monomeren in Betracht, vorzugsweise solche mit Siedepunkten über $100°$ C und Molekulargewichten < 1000. Diese Monomeren können teilweise durch eine oder mehrere oligomere Verbindungen mit mindestens einer ethylenisch ungesättigten Doppelbindung ersetzt sein, wobei die Molekulargewichte dieser Oligomeren im allgemeinen im Bereich zwischen 1000 und 10.000, vorzugsweise zwischen 1500 und 6000 liegen können.

Die photopolymerisierbaren Monomeren und Oligomeren können dabei sowohl mono- als auch polyfunktionell sein, d.h. eine oder mehrere photopolymerisierbare, ethylenische Doppelbindungen besitzen. Üblicherweise sind in der photopolymerisierbaren Aufzeichnungsschicht bi- oder mehrfunktionelle ethylenisch ungesättigte, photopolymerisierbare Verbindungen allein oder Mischungen hiervon mit einem untergeordneten Anteil an monofunktionellen ethylenisch ungesättigten, photopolymerisierbaren Verbindungen enthalten.

Als Vertreter für die photopolymerisierbaren Monomeren seien insbesondere die Derivate der (Meth)-acrylsäure und ganz besonders die (Meth)acrylsäureester genannt. Beispiele hierfür sind die Di- und Tri-(meth)acrylate von Ethylenglykol, Diethylenglykol, Triethylenglykol oder Polyethylenglykolen mit einem Molekulargewicht bis etwa 500, 1,2-Propandiol, 1,3-Propandiol, Polypropylenglykolen mit einem Molekulargewicht bis etwa 500, 1,4-Butandiol, 1,1,1-Trimethylolpropan, 2,2-Dimethylpropandiol, Glycerin oder Pentaerythrit; Pentaerythrittetra(meth)acrylat, Glucosetri- oder tetra-(meth)acrylat, ferner die Monoacrylate und Monomethacrylate der genannten Diole und Polyole, wie z.B. Ethylenglykol-, Di-, Tri- oder Tetraethylenglykolmono(meth)acrylat, Propandiol-mono(meth)acrylat und Butandiol-mono(meth)acrylat und die (Meth)acrylate von Monoalkanolen, insbesondere von solchen mit 1 bis 20 C-Atomen. Neben den bevorzugten Acrylaten und Methacrylaten der vorstehend genannten Art seien als photopolymerisierbare Monomere auch die Allyl-Verbindungen und andere Vinyl-Verbindungen genannt, wie z.B. N-Vinylpyrrolidon, N-Vinylcaprolactam, Vinylacetat, Vinylpropionat, (Meth)acrylamid, N-Methylol-(meth)acrylamid, der Bisether des Ethylenglykols und N-Methylol-(meth)acrylamids, Vinylcarbamate, Bisacrylamidoessigsäure und andere.

Geeignete ethylenisch ungesättigte, photopolymerisierbare Verbindungen für die erfindungsgemäßen lichtempfindlichen Aufzeichnungsschichten sind auch die monomeren Urethanacrylate bzw. -methacrylate mit zwei oder mehr Acryloyl- und/oder Methacryloyl-Gruppen. Solche monomeren Urethan(meth)acrylate können beispielsweise erhalten werden durch Umsetzung von aliphatischen Di- oder Polyolen mit organischen Diisocyanaten in einem Äquivalentverhältnis OH:NCO von etwa 1:2 und anschließende Umsetzung der freien Isocyanatgruppen des erhaltenen Reaktionsproduktes mit geeigneten Acryloyl- und/oder Methacryloyl-Verbindungen, beispielsweise Hydroxyalkyl-(meth)acrylaten. Als ali phatische Di- oder Polyole kommen unter anderem die vorstehend im Zusammenhang mit den Di- und Tri((meth)acrylaten genannten Di- und Polyhydroxy-Verbindungen in Betracht; als Beispiele für organische Diisocyanate seien Hexamethylendiisocyanat, Toluylendiisocyanat, Isophorondiisocyanat und ähnliche genannt; Hydroxyalkyl(meth)acrylate sind beispielsweise Hydroxyethyl-(meth)acrylat, Propandiol-mono(meth)acrylat oder Butandiol-mono(meth)-acrylat. Ebenso geeignet und vorteilhaft sind Monomere mit zwei oder mehr Acryloyl- und/oder Methacryloyl-Gruppen, wie sie beispielsweise erhalten werden können durch Umsetzung von Di-oder Polyglycidylverbindungen mit Acrylsäure und/oder Methacrylsäure. Als Di- und Polyglycidylverbindungen kommen hier insbesondere die Di-und Polyglycidylether mehrwertiger Phenole, beispielsweise des Bisphenols A oder der Substitutionsprodukte von Bisphenol A, in Betracht. Beispielhaft für solche Acryloyl-und/oder Methacryloyl-Gruppen enthaltenden Monomeren seien die Umsetzungsprodukte des Bisphenol A-bisglycidylethers mit Acryl- und/oder Methacrylsäure im molaren Verhältnis von etwa 1:2 hervorgehoben.

Die lichtempfindliche Schicht (ii) kann als photopolymerisierbare Verbindungen auch Oligomere mit 2 oder vorzugsweise mehr als 2 Acryloyl- und/oder Methacryloyl-Gruppen enthalten. Hierbei kann es sich beispielsweise um Acryloyl- und/oder Methacryloyl-Gruppen enthaltende oligomere Urethan-Harze oder um solche auf Basis von Di- oder Polyepoxiden handeln, wie sie als solche bekannt und in der Literatur beschrieben sind, wie z.B. solche Oligomeren die neben den Acryloyl-und/oder Methacryloyl-Gruppen zusätzlich noch freie Carboxylgruppen im Molekül enthalten. Die Oligomeren können so Säurezahlen im Bereich von 50 bis 150 mg KOH/g aufweisen. Geeignete photopolymerisierbare Oligomere dieser Art sind z.B. in der DE-A-24 42 527, der DE-C-25 57 408 oder auch der DE-A-29 17 483 beschrieben. Weitere photopolymerisierbare Oligomere können beispielsweise hergestellt werden, indem man die Hydroxylgruppen einer Acryloyl- und/oder Methacryloyl-Gruppen enthaltenden Diol- oder Polyol-Verbindung derart mit mehrfachen Carbonsäuren oder deren Derivaten, insbesondere cyclischen Carbonsäureanhydriden, umsetzt, daß sich die sauren Teilester der mehrfachen Carbonsäuren bilden, und anschließend einen Teil der freien Carboxylgruppen des so erhaltenen Reaktionsprodukts unter Kettenverlängerung sowie gegebenenfalls Verzweigung mit Di- und/oder Polyepoxiden umsetzt. Die Acryloyl-und/oder Methacryloyl-Gruppen enthaltenden Diol- oder Polyol-Verbindungen, die als Ausgangsprodukt für die Herstellung solcher Oligomeren dienen, werden zweckmäßigerweise hergestellt, indem man Di- oder Polyepoxid-Verbindungen, wie z.B. Di- oder Polyglycidylether bzw. Di-oder Polyglycidylester mit Acrylsäure und/oder Methaycrylsäure im Äquivalentverhältnis Glycidyl-Gruppen:COOH-Gruppen von etwa 1:1 umsetzt. Die Di- oder Polyepoxid-Verbindungen können dabei auch beispielsweise vor oder während der Umsetzung mit der (Meth)-acrylsäure durch Umsetzung mit Dicarbonsäuren vorverlängert werden. Beispielhaft und stellvertretend für Oligomere der letztgenannten Art seien die Produkte genannt, wie sie erhältlich sind durch Umsetzung von Bisphenol A-bisglycidylether mit Acryl- und/oder Methacrylsäure bzw. mit einem Gemisch aus etwa 30 bis 70 Mol.% einer Dicarbonsäure, beispielsweise Adipinsäure, und etwa 30 bis 70 Mol.% Acryl- und/oder Methacrylsäure im Äquivalentverhältnis Glycidyl-Gruppen:Gesamt-COOH von etwa 1:1, Umsetzung der Hydroxyl-Gruppen des so erhaltenen Reaktionsproduktes mit einem cyclischen Dicarbonsäureanhydrid, beispielsweise Phthalsäureanhydrid, gegebenenfalls in Mischung mit einem untergeordneten Anteil des Anhydrids einer anderen mehrfachen Carbonsäure, z.B. Trimellithsäureanhydrid, im Äquivalentverhältnis OH-Gruppen:Anhydrid-Gruppen von etwa 1:1 unter Bildung der sauren Teilester der mehrfachen Carbonsäuren und schließlich Umsetzung eines Teils der freien Carboxyl-Gruppen des so erhaltenen Reaktionsproduktes mit einem Di- und/oder Polyglycidylether, beispielsweise Bisphenol A-bisglycidylether oder Pentaerythrittriglycidylether, im Äquivalentverhältnis COOH-Gruppen:Glycidyl-Gruppen von größer 1:1, vorzugsweise im Bereich von etwa 1,15:1 bis 5:1. Derartige Oligomere sind beispielsweise in DE-A-34 47 355 beschrieben.

Die ethylenisch ungesättigten, photopolymerisierbaren Monomeren und deren Gemische mit Oligomeren werden dabei - für den Fachmann selbstverständlich - so gewählt, daß sie mit den als polymerem Bindemittel (a) eingesetzten Copolymerisaten verträglich sind. Das Mengenverhältnis von polymerem Bindemittel (a) zu den ethylenisch ungesättigten, photopolymerisierbaren Verbindungen (b) in der lichtempfindlichen Schicht (ii) kann in weiten Grenzen variiert werden und beispielsweise im Bereich von 1:99 bis 90:10 liegen. Ein niedriger Anteil an polymerem Bindemittel, beispielsweise im Bereich von etwa 1 bis 35 Gew.%, bezogen auf die photopolymerisierbare Schicht (ii), kommt insbesondere dann in Betracht, wenn in der photopolymerisierbaren Aufzeichnungsschicht als ethylenisch ungesättigte, photopolymerisierbare Verbindung ein hoher Anteil, beispielsweise 40 Gew.% oder mehr und insbesondere mehr als etwa 45 Gew.%, bezogen auf die photopolymerisierbare Aufzeichnungsschicht, an einem oder mehreren, mehr als zwei Acryloyl-und/oder Methacryloyl-Gruppen sowie freie Carboxyl-Gruppen enthaltenden Oligomeren enthalten ist.

c) Als Photoinitiatoren für die lichtempfindlichen Aufzeichnungsschichten kommen die für lichtempfindliche, photopolymerisierbare Aufzeichnungsmaterialien üblichen und an sich bekannten Photoinitiatoren bzw. Photoinitiatorsysteme in Betracht. Beispielhaft seien hierfür genannt: Benzoin, Benzoinether, insbesondere Benzoinalkylether, substituierte Benzoine, Alkylether von substituierten Benzoinen, wie z.B. α-Methylbenzoinalkylether oder α-Hydroxymethylbenzoinalkylether; Benzile, Benzilketale, insbesondere Benzildimethylketal, Benzilmethylethylketal oder Benzilmethylbenzylketal; die als Photoinitiator bekannten und wirksamen Acylphosphinoxid-Verbindungen, wie z.B. 2,4,6-Trimethylbenzoyldiarylphosphinoxid; Benzophenon, Derivate des Benzophenons, 4,4'-Dimethylaminobenzophenon, Derivate von Michler's Keton; Anthrachinon und substituierte Anthrachinone; arylsubstituierte Imidazole oder deren Derivate, wie z.B. 2,4,5-Triarylimidazoldimere; Thioxanthonderivate und die als Photoinitiatoren wirksamen Acridin- oder Phenacin-Derivate und N-Alkoxypyridiniumsalze und deren Derivate. Beispiele für Initiatorsysteme sind Kombinationen der genannten Initiatoren mit Sensibilisierungshilfsmitteln oder Aktivatoren, wie insbesondere tertiären Aminen. Typische Beispiele für solche Initiatorsysteme sind Kombinationen aus Benzophenon oder Benzophenon-Derivaten mit tertiären Aminen, wie Triethanolamin oder Michler's Keton; oder Gemische aus 2,4,5-Triarylimidazol-Dimeren und den Leukobasen von Triphenylmethanfarbstoffen. Die Auswahl der geeigneten Photoinitiatoren bzw. Photoinitiator-Systeme ist dem Fachmann geläufig. Besonders bevorzugte Photoinitiatoren sind Michlers Keton, Benzophenon, Hexaarylbisimidazol-Derivate und N-Alkoxypyridinium-Salze. Auch Mischungen der genannten Photoinitiatoren eignen sich sehr gut. Die Photoinitiatoren bzw. Photoinitiatorsysteme sind in der lichtempfindlichen Aufzeichnungsschicht im allgemeinen in Mengen von 0,1 bis 10 Gew.%, bezogen auf die lichtempfindliche Aufzeichnungsschicht, enthalten.

Als weitere Zusatz- und/oder Hilfsstoffe, die in der erfindungsgemäßen lichtempfindlichen Aufzeichnungsschicht enthalten sein können, kommen z.B. Farbstoffe und/oder Pigmente, photochrome Verbindungen bzw. Systeme, sensitometrische Regler, Weichmacher, Verlaufshilfsmittel, Mattierungs- oder Gleitmittel und dergleichen in Betracht. Beispiele für Farbstoffe und/oder Pigmente, die sowohl als Kontrastmittel als auch schichtverfestigend wirken können, sind u.a. Brilliant Green Dye (C.I. 42 040), Viktoria-Reinblau FGA, Viktoria-Reinblau BO (C.I. 42 595), Viktoria-Blau B (C.I. 44 045), Rhodamin 6 G (C.I. 45 160), Triphenylmethanfarbstoffe, Naphthalimidfarbstoffe und 3'-Phenyl-7-dimethylamino-2,2'-spiro-di-(2H-1-benzopyran).

Photochrome oder Farbumschlag-Systeme, die bei Belichtung mit aktinischem Licht reversibel oder irreversibel ihre Farbe ändern, ohne hierbei den Photopolymerisationsprozeß zu stören, sind z.B. Leukofarbstoffe zusammen mit geeigneten Aktivatoren. Als Beispiele für Leukofarbstoffe seien die Leukobasen der Triphenylmethanfarbstoffe, wie Kristallviolett-Leukobase und Malachitgrün-Leukobase, Leuko-Basischblau, Leuko-Pararosanilin, Leuko-Patentblau A oder V genannt; ferner kommt auch Rhodamin B-Base in Betracht. Als Aktivatoren für diese photochromen Verbindungen kommen u.a. organische Halogenverbindungen, die bei Belichtung mit aktinischem Licht Halogenradikale abspalten, oder Hexaarylbisimidazole in Betracht. Geeignete Farbumschlagsysteme sind auch in DE-A-38 24 551 beschrieben. Zu den sensitometrischen Reglern gehören Verbindungen wie z.B. 9-Nitroanthracen, 10, 10'-Bisanthron, Phenazinium-, Phenoxazinium-, Acridinium-, Phenothiazinium-Farbstoffe, 1,3-Dinitrobenzole und ähnliche, insbesondere in Kombination mit milden Reduktionsmitteln. Als Weichmacher können die an sich bekannten und üblichen niedermolekularen oder hochmolekularen Ester, wie Phthalate oder Adipate, Toluolsulfonamid oder Tricresylphosphat, dienen. Die Zusatz- und/oder Hilfsstoffe sind in den photopolymerisierbaren Aufzeichnungsschichten in den für diese Stoffe üblichen und bekannten wirksamen Mengen vorhanden. Ihre Menge sollte jedoch im allgemeinen 30 Gew.%, vorzugsweise 20 Gew.% bezogen auf die lichtempfindliche Aufzeichnungsschicht, nicht überschreiten.

Das Mischungsverhältnis, in dem die einzelnen Komponenten in der lichtempfindlichen Schicht (ii) enthalten sind, wird im allgemeinen so gewählt, daß diese Schicht nicht nur wäßrig-alkalisch entwickelbar, sondern vorteilhafterweise auch bei Raumtemperatur fest und nicht klebrig ist und gute Filmbildungseigenschaften besitzt. Für den Einsatz der erfindungsgemäßen lichtempfindlichen Aufzeichnungsmaterialien als

**EP 0 387 822 A1**

Photoresistfilm wird die Zusammensetzung darüber hinaus zweckmäßigerweise so gewählt, daß die lichtempfindliche Schicht (ii) gut laminierbar und unter Anwendung von Druck sowie gegebenenfalls Wärme auf ein Substrat übertragbar ist. für die Herstellung von Resistmustern werden üblicherweise Schichtdicken der lichtempfindlichen Schicht (ii) im Bereich von etwa 1 bis 50 μm eingestellt.

Die lichtempfindliche Schicht (ii) kann zum Beispiel aus einer homogenen, filmbildenden und in wäßrig-alkalischen Lösungen löslichen oder zumindest dispergierbaren Mischung von

a) 40 bis 90 Gew.% mindestens eines Copolymerisats der vorstehend genannten Art als polymerem Bindemittel,

b) 8 bis 55 Gew.% mindestens eines ethylenisch ungesättigten, photopolymerisierbaren, mit dem bzw. den polymeren Bindemitteln verträglichen Monomeren, bei hohen Monomer-Gehalten gegebenenfalls auch in Mischung zusammen mit einer untergeordneten Menge an einem oder mehreren, verträglichen, photopolymerisierbaren Oligomeren,

c) 0,05 bis 5 Gew.% mindestens eines Photopolymerisationsinitiators sowie

d) 0 bis 30 Gew.% vorzugsweise 0,05 bis 20 Gew.% an weiteren, die allgemeinen Eigenschaften der Aufzeichnungselemente bzw. der hieraus hergestellten Druckformen oder Resistmuster verbessernden bzw. modifizierenden Zusatz- und/oder Hilfsstoffen bestehen.

Als lichtempfindliche Schicht (ii) können auch positiv arbeitende lichtempfindliche Zusammensetzungen gewählt werden.

Solche positiv arbeitenden lichtempfindlichen Zusammensetzungen, d.h. Verbindungen oder Gemische von Verbindungen, deren Löslichkeit in einem vorgegebenen Lösungsmittel bei Bestrahlung zunimmt, sind an sich bekannt. Die in der Reproduktionstechnik am häufigsten eingesetzten Verbindungen sind Naphthochinondiazide oder deren Derivate (vgl. W. Fraß, Chemie in unserer Zeit, 17 (1983), 10; H.W. Vollmann, Angew. Chem. 92 (1980), 95).

Eine weitere Verbindungsklasse, die sich zur Herstellung von positiv arbeitenden lichtempfindlichen Gemischen eignet, sind aromatische oder heteroaromatische Nitroverbindungen. Während die oben beschriebenen Verbindungen mit Diazoketon-Struktur in den lichtempfindlichen Gemischen meist als niedermolekulare Verbindungen vorliegen, können als lichtempfindliche Nitroverbindungen sowohl niedermolekulare Verbindungen (DE-A-22 07 574, US-A-4 181 531) als auch Polymere aus Monomeren mit o-Nitrocarbinolester-Struktur bzw. Copolymere dieser Monomerer mit anderen Vinylverbindungen verwendet werden (DE-A-21 50 691, DE-A-29 22 746, EP-A-19 770).

Ein weiteres positiv arbeitendes Gemisch ist z.B. in EP-A-62 474, EP-A-99 949 oder US-A-4 415 652 beschrieben. Hier wird ein Gemisch aus einem in wäßriger Lösung unlöslichen Bindemittel, einer Mercaptocarbonsäure und einem bei Bestrahlung Radikale bildenden Initiatorsystem beansprucht. Die Bestrahlung führt zu einer radikalischen Pfropfung der Mercaptocarbonsäure auf das Bindemittel, das dadurch in wäßrig-alkalischen Lösungen löslich wird.

Beispiele für weitere positiv arbeitende lichtempfindliche Zusammensetzungen sind z.B. Polyoxymethylen-Polymere, die in der Hauptkette Acetaleinheiten, die aus o-Nitrobenzaldehyd oder Derivaten des o-Nitrobenzaldehyds gebildet sind, enthalten. Solche Polymere und aus ihnen hergestellte lichtempfindliche Schichten sind z.B. in US-A-3 991 033 und US-A-4 189 611 beschrieben. Auf ähnliche Weise können Acetale des o-Nitrobenzaldehyds auch in die Hauptkette von Polymeren eingebaut werden, die im wesentlichen einen Polyester aus einer Dicarbonsäure und einem difunktionellen Alkohol darstellen (US-A-4 086 210).

Falls erforderlich kann die photoempfindliche Schicht (ii) auf der der löslichen Trägerfolie abgewandten Seite mit einer Deckfolie (z.B. aus Polyethylen oder Polypropylen) versehen werden.

Zur Herstellung einer gedruckten Schaltung, wird zweckmäßigerweise in der angegebenen Reihenfolge, ein Photoresistfilm, bestehend aus einer Trägerfolie und einer photoempfindlichen Schicht, die beide in Wasser oder der gleichen wäßrigen Lösung löslich oder dispergierbar sind, so auf ein kupferkaschiertes Leiterplattensubstrat auflaminiert, daß die photoempfindliche Schicht in Kontakt zur Kupferoberfläche steht. Die photoempfindliche Schicht wird dann durch die Trägerfolie hindurch bildmäßig belichtet und schließlich werden die Trägerfolie und die löslichen Stellen der photoempfindlichen Schicht durch Lösen oder Dispergieren entfernt. Die bildmäßige Belichtung erfolgt in üblicher Weise mit aktinischem Licht, wobei sich hierfür die üblichen Lichtquellen von aktinischem Licht, wie beispielsweise UV-Fluoreszenzröhren, Quecksilberhoch-, -mittel- oder -niederdruckstrahler, superaktinische Leuchtstoffröhren, Xenon-Impulslampen, aber auch UV-Laser, Argonlaser und ähnliche, eignen. Die von den Lichtquellen emittierte Wellenlänge soll im allgemeinen zwischen 230 und 450 nm, bevorzugt zwischen 300 und 420 nm, liegen und insbesondere auf die Eigenabsorption des in der photopolymerisierbaren Schicht (ii) enthaltenen Photoinitiators abgestimmt sein. Die löslichen Stellen der photoempfindlichen Schicht sind bei negativ arbeitenden Resisten die unbelichteten Stellen, bei positiv arbeitenden Resisten die belichteten Stellen. Im Falle eines

7

negativ arbeitenden Resists wird nach der bildmäßigen Be lichtung das Resistmuster durch Auswaschen der unbelichteten, unvernetzten Bereiche der Aufzeichnungsschicht mit einer wäßrig-alkalischen Entwicklerlösung entwickelt. Das Entwickeln kann durch Waschen, Sprühen, Reiben, Bürsten etc. erfolgen. Als Entwicklerlösungen kommen insbesondere wäßrig-alkalische Lösungen in Betracht, die zur Einstellung des günstigsten pH-Wertes, im allgemeinen im Bereich von 8 bis 14, vorzugsweise im Bereich von etwa 9 bis 13, alkalisch reagierende Substanzen, wie z.B. Borax, Dinatriumhydrogenphosphat, Soda, Alkalihydroxide oder organische Basen, wie Di- oder Triethanolamin in Wasser gelöst, enthalten. Die wäßrig-alkalischen Entwicklerlösungen können auch Puffersalze, z.B. wasserlösliche Alkaliphosphate, -silikate, -borate, -acetate oder -benzoate enthalten. Als weitere Bestandteile der Entwicklerlösungen können Netzmittel, vorzugsweise anionische Netzmittel, und gegebenenfalls wasserlösliche Polymere, wie z.B. Natriumcarboxymethylcellulose, Polyvinylalkohol, Polynatriumacrylat und dergleichen, mitverwendet werden. Obwohl die erfindungsgemäßen Aufzeichnungselemente im allgemeinen mit rein wäßrig-alkalischen Entwicklerlösungen ausgewaschen werden, ist es selbstverständlich grundsätzlich möglich, wenn auch nicht erforderlich, daß die wäßrig-alkalischen Entwicklerlösungen auch noch geringe Zusätze an wasserlöslichen organischen Lösungsmitteln, wie z.B. aliphatischen Alkoholen, Aceton oder Tetrahydrofuran, enthalten. Das Entfernen von Trägerfolie und photoempfindlicher Schicht erfolgt dabei in einem Arbeitsgang.

Der Vorteil der erfindungsgemäßen lichtempfindlichen Aufzeichnungsmaterialien gegenüber herkömmlichen Systemen mit unlöslichen Trägerfolien besteht darin, daß das kostenintensive Abziehen der Trägerfolie entfällt, ohne daß es zu einer Beeinträchtigung der übrigen Eigenschaften der lichtempfindlichen Aufzeichnungsschicht kommt. Da beim Entfernen der Trägerfolie keine mechanische Beanspruchung der photoempfindlichen Schicht auftritt, kommt es auch nicht zu einer partiellen Ablösung der photoempfindlichen Schicht vom Substrat, wie sie bei herkömmlichen Resisten durch das Abziehen der Trägerfolie verursacht wird. Im Gegensatz zu manchen früher beschriebenen Verfahren kommen die bildmäßigen Vorlagen bei dem erfindungsgemäßen Verfahren nur mit der Trägerfolie in Kontakt, deren Zusammensetzung so gewählt wird, daß eine völlig klebfreie Oberfläche entsteht. Eine Verschmutzung der bildmäßigen Vorlagen wird dadurch vermieden.

Die Erfindung wird durch die nachstehende Beispiele näher erläutert.

Die in den Beispielen genannten Teile und Prozente sind, soweit nicht anders angegeben, Gewichtsteile bzw. Gewichtsprozente.

Beispiel 1

Eine Gießlösung zur Herstellung eines Photoresistfilms wurde durch Mischen der folgenden Komponenten hergestellt:

| (1) | 37 %ige Lösung (in Methylethylketon/propanol 1/1) eines Copolymeren aus Styrol (23 %), Methylmethacrylat (35 %), Butylacrylat (11 %) und Methacrylsäure (30 %) mit einem K-Wert nach Fikentscher von 42 | 149,80 g |
| (2) | Trimethylolpropantriacrylat | 38,00 g |
| (3) | Sicomet® Patentblau 80E131 | 0,05 g |
| (4) | Isopropylthioxanthon | 0,50 g |
| (5) | Ethyl-(p-dimethylamino)benzoat | 3,00 g |

Die filtrierte Lösung wurde so auf eine 30 μm starke Folie aus Polyvinylalkohol (Typ L 335 der Firma Aquafilm Ltd.) gegossen, daß nach dem Ablüften des Lösungsmittels und Trocknen (3 Minuten bei 80° C) eine Trockenschichtdicke der photoempfindlichen Schicht von 35 μm resultierte. Die so hergestellte photopolymerisierbare Resistschicht wurde bis zur Weiterverarbeitung mit einer Polyethylenfolie abgedeckt. Zur Prüfung wurde die Polyethylenfolie entfernt, der Photoresistfilm bei 80 bis 120° C auf ein kupferkaschiertes Leiterplattensubstrat auflaminiert und in einem Riston-PC-Printer (Hersteller: Fa. E.I. Du Pont de Nemours) bildmäßig mit aktinischem Licht durch ein Testnegativ belichtet. Nach der Belichtung wurde der Resist, ohne Abziehen der Trägerfolie, bei 30° C mit einer 1 %igen wäßrigen Sodalösung entwickelt. Die Verweilzeit in der Sodalösung betrug 100 Sekunden.

Zum Vergleich wurde die gleiche Gießlösung auf eine 23 μm starke Polyesterfolie gegossen. Dieser Resist wurde analog verarbeitet. Nach dem Belichten wurde jedoch zunächst die Polyesterfolie abgezogen und der Resist erst dann entwickelt. Die Verweilzeit im Entwickler betrug hier 50 Sekunden. Mit beiden Resisten wurden umfangreiche Prüfungen durchgeführt. Dabei wurden keine Unterschiede hinsichtlich der für die Leiterplattenfertigung wichtigen Resisteigenschaften (Ätzbeständigkeit, Verhalten in den Galvanikbädern, Tenting, Strippverhalten, Auflösung) festgestellt.

Beispiel 2

Eine 20 %ige wäßrige Lösung eines vollverseiften Polyvinylalkohols (Viskosität nach DIN 53 015: 4 mPas; Hydrolysegrad: 98 mol-%) wurde so auf eine 23 μm starke Polyesterfolie gegossen, daß eine Trockenschichtdicke der Polyvinylalkoholschicht von 30 μm resultierte. Nach dem Ablüften der Schicht wurde auf die beschichtete Seite der Polyesterfolie die Gießlösung des Beispiels 1 aufgebracht. Es resultierte eine Trockenschichtdicke der photoempfindlichen Schicht von 38 μm. Die photoempfindliche Schicht wurde nun mit einer 23 μm starken Polyethylenfolie abgedeckt. Danach wurde die Polyesterfolie von dem Folienverbund aus Polvinylalkohol, photoempfindlicher Schicht und Polyethylenfolie abgezogen, wobei eine problemlose Trennung zwischen Polyester und Polyvinylalkohol erfolgte, ohne daß Delamination an anderen Stellen des Verbundes beobachtet wurde. Schließlich wurde das Resistmaterial auf eine Rolle gewickelt. Zur Prüfung wurde der Resist von der Rolle abgewickelt, die Polyethylenfolie abgezogen und der Resistfilm mit der photoempfindlichen Schicht zum Kupfer auf die kupferkaschierte Oberfläche eines Leiterplattensubstrates laminiert (105 °C; 1,5 m/min). Nach der Belichtung wurde 45 Sekunden in 1 %iger Sodalösung entwickelt. Bei der weiteren Prüfung konnten keine Unterschiede zu dem in Beispiel 1 hergestellten Produkt festgestellt werden.

Beispiel 3

Ein weiterer Resistfilm mit löslicher Trägerfolie wurde analog zu Beispiel 1 hergestellt, indem der dort beschriebene Polyvinylalkohol durch ein verseiftes Pfropfpolymerisat von Vinylacetat auf Polyethylenglykol (Molekulargewicht 30.000 bis 35.000; Gehalt an Polyethylenglykol: 24 %; Verseifungsgrad 82 mol-%) ersetzt wurde. Die Entwicklungszeit betrug 50 Sekunden.

**Ansprüche**

1. Lichtempfindliches Aufzeichnungsmaterial, bestehend aus
(i) einer Trägerfolie;
(ii) einer photoempfindlichen positiv oder negativ arbeitenden Schicht und
(iii) gegebenenfalls darauf aufgebrachten weiteren Schichten,
dadurch gekennzeichnet, daß die Trägerfolie (i) und die nach der bildmäßigen Belichtung zu entfernenden Bereiche der Schicht (ii) in der gleichen Entwicklerlösung löslich oder dispergierbar sind und es sich bei dieser Entwicklerlösung um Wasser oder eine wäßrige Lösung handelt.

2. Lichtempfindliches Aufzeichnungsmaterial nach Anspruch 1, dadurch gekennzeichnet, daß die Trägerfolie (i) durch Extrusion hergestellt worden ist.

3. Lichtempfindliches Aufzeichnungsmaterial nach Anspruch 1, dadurch gekennzeichnet, daß die Trägerfolie (i) durch Gießen hergestellt worden ist.

4. Lichtempfindliches Aufzeichnungsmaterial nach einem der vorhergehenden Ansprüche, dadurch gekennzeichnet, daß die Trägerfolie (i) aus vollständig oder teilweise verseiftem Polyvinylacetat besteht.

5. Lichtempfindliches Aufzeichnungsmaterial nach einem der vorhergehenden Ansprüche, dadurch gekennzeichnet, daß die photoempfindliche Schicht (ii) mit einer Deckfolie abgedeckt ist.

6. Verfahren zur Herstellung einer gedruckten Schaltung, wobei in der angegebenen Reihenfolge (1) ein lichtempfindliches Aufzeichnungsmaterial nach einem der vorhergehenden Ansprüche, gegebenenfalls nach Abziehen der Deckfolie, so auf ein kupferkaschiertes Leiterplattensubstrat auflaminiert wird, daß die photoempfindliche Schicht (ii) in Kontakt zur Kupferoberfläche steht, (2) die lichtempfindliche Aufzeichnungsschicht bildmäßig belichtet wird, (3) die Trägerfolie und die löslichen Stellen der photoempfindlichen Schicht in einer wäßrigen Entwicklerlösung entfernt werden und (4) die freigelegte Kupferoberfläche den üblichen weiteren Bearbeitungsschritten, wie Ätzen oder galvanischer Metallabscheidung, unterworfen wird.

7. Verfahren zur Herstellung einer gedruckten Schaltung nach Anspruch 6, dadurch gekennzeichnet, daß es sich bei der Entwicklerlösung um eine wäßrige Natriumcarbonat-Lösung handelt.

Europäisches
Patentamt

**EUROPÄISCHER RECHERCHENBERICHT**

## EINSCHLÄGIGE DOKUMENTE

EP 90104780.3

| Kategorie | Kennzeichnung des Dokuments mit Angabe, soweit erforderlich, der maßgeblichen Teile | Betrifft Anspruch | KLASSIFIKATION DER ANMELDUNG (Int Cl⁵) |
|---|---|---|---|
| X | DERWENT ACCESSION No. 81-92 051D (50), Questel Telesystems (WPIL) DERWENT PUBLICATIONS LTD., London <br> * Abstract * <br> & JP-A-56 140 341 <br> (MUROMACHI) <br> -- | 1,4-7 | G 03 F 7/09 <br> G 03 F 7/30 <br> H 05 K 3/06 |
| X | DERWENT ACCESSION No. 79-88 545B (49), Questel Telesystems (WPI) DERWENT PUBLICATIONS LTD., London <br> * Abstract * <br> & JP-A-54 139 720 <br> (ASAHI CHEMICAL) <br> ---- | 1,4-6 | |

| RECHERCHIERTE SACHGEBIETE (Int Cl⁵) |
|---|
| G 03 F <br> H 05 K |

Der vorliegende Recherchenbericht wurde für alle Patentansprüche erstellt.

| Recherchenort <br> WIEN | Abschlußdatum der Recherche <br> 23-06-1990 | Prüfer <br> BÖHM |
|---|---|---|